# EUROPEAN PATENT APPLICATION

(11) **EP 4 723 856 A1**
(43) Date of publication of application: **08.04.2026**
(21) Application number: 24815851.1
(22) Date of filing: 29.05.2024
(51) Int. Cl.: H10K 59/80, H10K 59/12, H10K 71/40, H10K 102/00

(54) **DISPLAY DEVICE AND MANUFACTURING METHOD THEREFOR**

(30) Priority: 31.05.2023 KR 20230070497
(71) Applicant: Samsung Display Co., Ltd., Yongin-si, Gyeonggi-do 17113 (KR)
(72) Inventor: KIM, Myung Hwan, Yongin-Si Gyeonggi-do 17113 (KR)
(74) Representative: Marks & Clerk LLP
(86) International application number: PCT/KR2024/007310
(87) International publication number: WO 2024/248475

(57) **Abstract**

A display device according to an embodiment of the present invention comprises: a display panel including a display area; a cover window disposed on the display panel; and a protective member disposed under the display area of the display panel, wherein the protective member has an elastic modulus of 4 GPa or less in a glass transition temperature range, and has a shrinkage rate of 20% or more in a temperature range of 50 degrees to 150 degrees.

## Description

### [TECHNICAL FIELD]

The present disclosure relates to a display device and a method of fabricating the same.

### [BACKGROUND ART]

As the information-oriented society evolves, various demands for display devices are ever increasing. For example, display devices are being employed by a variety of electronic devices such as smart phones, digital cameras, laptop computers, navigation devices, and smart televisions.

As such display devices, a variety of types of display devices such as liquid-crystal display (LCD) devices and organic light-emitting display (OLED) devices are currently used. Among them, an organic light-emitting display device displays images by using an organic light-emitting element that emits light as electrons and holes recombine. Such an organic light-emitting display device includes a plurality of transistors for providing a driving current to the organic light-emitting element.

As display devices are employed by various electronic devices, display devices are required to have various designs. For example, images can be displayed not only on the front surface of a display device but also on the curved portions at four edges of the front surface and on the corners between the curved portions.

### [DISCLOSURE]

### [TECHNICAL PROBLEM]

Aspects of the present disclosure provide a display device that can prevent adhesion failure at corners, and a method of fabricating a display device.

However, aspects of the present disclosure are not restricted to those set forth herein. The above and other aspects of the present disclosure will become more apparent to one of ordinary skill in the art to which the present disclosure pertains by referencing the detailed description of the present disclosure given below.

### [TECHNICAL SOLUTION]

According to an aspect of the present disclosure, a display device comprises a display panel comprising a display area, a cover window disposed on the display panel, and a protection member disposed under the display area of the display panel, wherein the protection member has an elastic modulus of 4 GPa or less in a range of glass transition temperature, and a contraction rate of 20% or more in a temperature range of 50 to 150 degrees Celsius.

The display area may comprise a flat front surface, side surfaces extended outward from edges of the front surface and curved with curvatures, and corner sections each located between adjacent ones of the side surfaces and having double curvatures.

The protection member may be attached to all of the front surface, the side surfaces, and the corner sections.

The display device may further comprise a first coupling layer disposed between the display panel and the protection member, and a second coupling layer disposed between the display panel and the cover window.

The glass transition temperature of the protection member may range from 50 to 150 degrees Celsius.

The protection member may have an elastic modulus of 0.6 to 0.9 GPa at a temperature range of 74 to 78 degrees.

The protection member may comprise at least one of polyolefin-based, polyvinyl-based, polyethylene-based, and polyester-based resins.

The protection member may have a thickness of 25 µm to 100 µm.

According to an aspect of the present disclosure, a display device comprises a display panel comprising a display area and a bonding area spaced apart from the display area, a cover window disposed on the display panel, a first protection member disposed under the display area of the display panel, and a second protection member disposed under the bonding area of the display panel and spaced apart from the first protection member, wherein a contraction rate of the second protection member is smaller than a contraction rate of the first protection member.

The contraction rate of the second protection member and the contraction rate of the first protection member may be measured in a temperature range of 50 to 150 degrees Celsius.

The second protection member may have a contraction rate of 1% or less in a temperature range of 50 to 150 degrees Celsius.

The second protection member may have a coefficient of thermal expansion of 30 ppm/°C or less in a temperature range of room temperature to 180 degrees Celsius.

A melting point of the second protection member may be equal to or greater than 180 degrees.

An elastic modulus of the second protection member may be greater than an elastic modulus of the first protection member in a temperature range of 50 to 150 degrees Celsius.

The second protection member may have an elastic modulus of 4.5 GPa or more in a temperature range of 50 to 150 degrees Celsius.

According to an aspect of the present disclosure, a method of fabricating a display device comprises preparing a display panel, a first protection member and a second protection member, attaching a first protection member and a second protection member to a lower surface of the display panel, aligning a cover window on the display panel and a guide member under the display panel, pressing the cover window, the display panel and the guide member, heating the first protection member of the display panel through the guide member, and removing the guide member, wherein an elastic modulus of the second protection member is greater than an elastic modulus of the first protection member.

The guide member may comprise a flat portion, curved portions extended outward from edges of the flat portion and curved with curvatures, and double-curved portions each located between adjacent ones of the curved portions and having double curvatures.

The guide member may comprise first heaters disposed at the double-curved portions, and may apply heat to the display panel and the first protection member through the first heaters.

The guide member may further comprise second heaters disposed at the curved portions, and may apply heat to the display panel and the first protection member through the first heaters and the second heaters.

A contraction rate of the second protection member may be smaller than a contraction rate of the first protection member in a temperature range of 50 to 150 degrees Celsius.

Other features and embodiments may be apparent from the following detailed description and the drawings.

### [ADVANTAGEOUS EFFECTS]

According to an embodiment of the present disclosure, it is possible to prevent adhesion failure between a display panel and a protection member in a display device as the protection member is deformed at corners having double curvatures. Accordingly, it is possible to prevent buckling defects between the display panel and the protection member, thereby preventing cracks and disconnection of the display panel.

The effects according to the embodiments are not limited by the contents exemplified above, and more various effects are included in this disclosure.

### [DESCRIPTION OF DRAWINGS]

FIG. 1 is a perspective view showing a display device according to an embodiment of the present disclosure.
FIG. 2 is a plan view showing a display device according to an embodiment of the present disclosure.
FIG. 3 is a cross-sectional view showing an example of the display panel taken along line Q1 - Q1' of FIG. 2.
FIG. 4 is a plan view schematically showing pixels of the display area of the display device according to the embodiment.
FIG. 5 is a cross-sectional view taken along line Q2 - Q2' of FIG. 4.
FIG. 6 is a plan view showing a display panel of a display device according to another embodiment of the present disclosure.
FIG. 7 is a cross-sectional view taken along line Q3 - Q3' of FIG. 6.
FIG. 8 is a cross-sectional view showing another example, taken along line Q3 - Q3' of FIG. 6.
FIG. 9 is a flowchart for illustrating a method for fabricating a display device according to an embodiment of the present disclosure.
FIGS. 10 to 17 are views showing processing steps of a method of fabricating a display device according to an embodiment of the present disclosure.
FIG. 18 is a graph showing glass transition temperatures of samples of protection members according to an embodiment.
FIG. 19 is a graph showing elastic modulus at glass transition temperatures of the samples of the protection members according to the embodiment.

### [MODES OF THE INVENTION]

The advantages and features of the present invention, and the methods for achieving them, will become apparent with reference to the embodiments described in detail below together with the accompanying drawings. However, the present invention is not limited to the embodiments disclosed hereinafter but will be embodied in various different forms, and these embodiments are merely provided so that the disclosure of the present invention is complete and to fully inform those skilled in the art to which the present invention pertains of the scope of the invention, and the present invention is defined by the scope of the claims.

When an element or a layer is referred to as being "on" another element or layer, this includes both a case where it is directly on the other element, and a case where another layer or element is interposed therebetween. Likewise, references to "below," "left," and "right" of another element also include both cases where they are directly adjacent and cases where another layer or material is interposed therebetween. Throughout the specification, the same reference numerals refer to the same components.

Although terms such as first, second, etc. are used to describe various components, these components are not limited by these terms. These terms are merely used to distinguish one component from another. Thus, a first component mentioned below may also be a second component within the technical spirit of the present invention.

Hereinafter, embodiments of the present disclosure will be described with reference to the drawings.

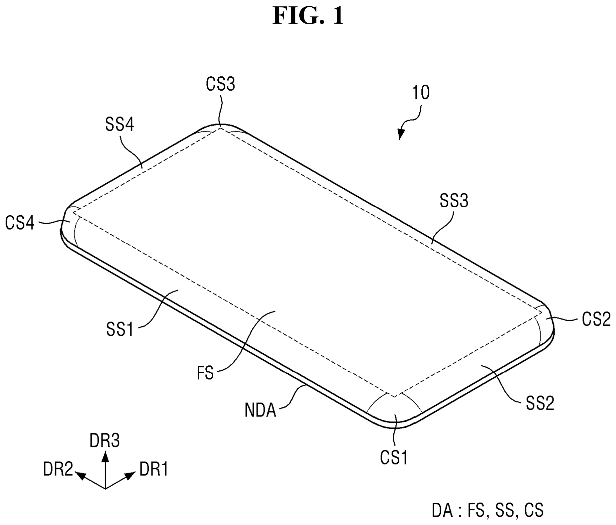

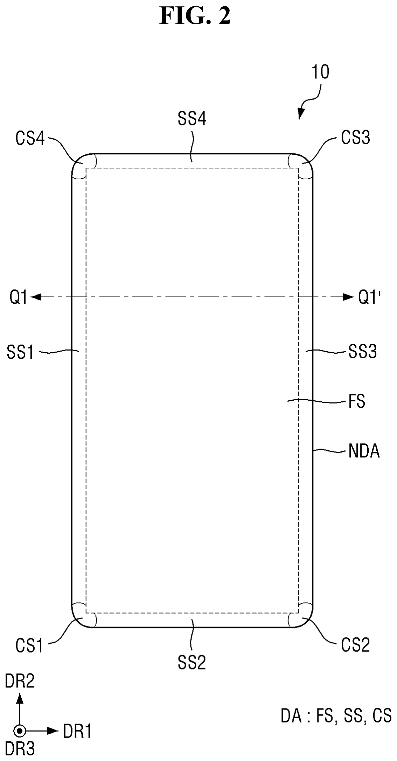

FIG. 1 is a perspective view showing a display device according to an embodiment of the present disclosure. FIG. 2 is a plan view showing a display device according to an embodiment of the present disclosure.

Referring to FIGS. 1 and 2, the display device 10 according to the embodiment may include a variety of devices that display images or videos. For example, the display device 10 according embodiments of the present disclosure may be applied to a mobile phone, a tablet PC, a personal digital assistant (PDA), a portable multimedia player (PMP), a television set, a game machine, a wristwatch-type electronic device, a head-mounted display, a personal computer monitor, a laptop computer, a car navigation system, a car instrument cluster, a digital camera, a camcorder, an outdoor billboard, an electronic billboard, various medical apparatuses, various home appliances such as a refrigerator and a laundry machine, Internet of things (IoT) devices, etc., in addition to a smart phone.

As used herein, the shorter sides of the display device 10 may be extended in parallel to the first direction DR1, and the longer sides of the display device 10 may be extended in parallel to the second direction DR2 when viewed from the top. For example, the first direction DR1 and the second direction DR2 may intersect each other such that they are perpendicular to each other, the first direction DR1 may be the horizontal direction of the display device 10 when viewed from the top, and the second direction DR2 may be the vertical direction of the display device 10 when viewed from the top. The third direction DR3 may be perpendicular to the first direction DR1 as well as the second direction DR2 and may refer to the thickness direction of the display device 10, for example.

The display device 10 may include a display area DA and a non-display area NDA.

In the display area DA, images may be displayed. The display area DA may include pixels and/or emission areas. The display area DA may include a front surface FS, side surfaces SS: SS1, SS2, SS3 and SS4, and corner sections CS: CS1, CS2, CS3 and CS4. The front surface FS, the side surfaces SS: SS1, SS2, SS3 and SS4, and the corner sections CS: CS1, CS2, CS3 and CS4 may be substantially included in a cover window CW to be described below.

The entire front surface FS may be substantially flat, but the present disclosure is not limited thereto. At least a part of the front surface FS may include a convex or concave shape in the thickness direction (the third direction DR3). The front surface FS may include a rectangular shape having shorter sides in the first direction DR1 and longer sides in the second direction DR2. The front surface FS may have rounded corners when viewed from the top. The front surface FS may have rounded polygonal corners when viewed from the top. For example, as shown in FIG. 1, the front surface FS may have a rectangular shape with rounded corners, but the present disclosure is not limited thereto.

The side surfaces SS: SS1, SS2, SS3 and SS4 may be extended outward from the edges of the front surface FS to be bent at a predetermined angle. For example, the side surfaces SS may be bent from the front surface FS at an angle equal to or greater than 90 degrees and less than 180 degrees. When the front surface FS has a rectangular shape when viewed from the top, the side surfaces SS may include a first side surface SS1 and a third side surface SS3 extended from the front surface FS toward one side and the opposite side in the first direction DR1, respectively, and may include a second side surface SS2 and a fourth side surface SS4 extended toward one side and the opposite side in the second direction DR2, respectively. The first and third side surfaces SS1 and SS3 may be referred to a pair of first side surfaces, and the second and fourth side surfaces may be referred to a pair of second side surfaces. The first to fourth side surfaces SS1, SS2, SS3 and SS4 may have substantially the same function or configuration except for their positions.

Each of the side surfaces SS: SS1, SS2, SS3 and SS4 may have, but is not limited to, a rounded shape when viewed from the top. For example, the first side surface SS1 may include rounded shapes on one side and the opposite side in the second direction DR2, respectively. It is, however, to be understood that the present disclosure is not limited thereto.

The first to fourth side surfaces SS1, SS2, SS3 and SS4 may be extended from the front surface FS to have predetermined curvatures and may have a round shape. The first to fourth side surfaces SS1, SS2, SS3 and SS4 may have a convex shape toward the outside of the display device 10. For example, the first side surface SS1 may include a first curvature, and the second side surface SS2 may include a second curvature. The third side surface SS3 may include a third curvature, and the fourth side surface SS4 may include a fourth curvature. The first to fourth curvatures may be all equal, but the present disclosure is not limited thereto. The first to fourth curvatures may be different from one another, or only some of the first to fourth curvatures may be equal to one another. In some embodiments, the first curvature and the third curvature may be the same. In some embodiments, the second curvature and the fourth curvature may be the same.

The portions that are curved outward from the front surface FS of the display device 10 between adjacent side surfaces SS: SS1, SS2, SS3 and SS4 are defined as the corner sections CS. The first to fourth side surfaces SS1, SS2, SS3 and SS4 may be spaced apart from each other with a predetermined distance at at least some positions. The corner sections CS: CS1, CS2, CS3 and CS4 may be located at the positions where the first to fourth side surfaces SS1, SS2, SS3 and SS4 are spaced apart from each other.

For example, a first corner section CS1 may be disposed between the first side surface SS1 and the second side surface SS2, a second corner section CS2 may be disposed between the second side surface SS2 and the third side surface SS3, a third corner section CS3 may be disposed between the third side surface SS3 and the fourth side surface SS4, and a fourth corner section CS4 may be disposed between the fourth side surface SS4 and the first side surface SS1. The first corner section CS1 may connect the first and second side surfaces SS1 and SS2 with each other. The second corner section CS2 may connect the second and third side surfaces SS2 and SS3 with each other. The third corner section CS3 may connect the third and fourth side surfaces SS3 and SS4 with each other. The fourth corner section CS4 may connect the fourth and first side surfaces SS4 and SS1 with each other. The corner sections CS1, CS2, CS3 and CS4 may have substantially the same function or configuration except for their positions.

The first to fourth corner sections CS1, CS2, CS3 and CS4 all may include the curvatures of adjacent side surfaces and may have a round shape. For example, the first corner section CS1 may be located between the first side surface SS1 and the second side surface SS2. In this instance, the first corner section CS1 may have a double curvature including the first curvature of the first side surface SS1 and the second curvature of the second side surface SS2. For example, a curvature of the first corner section CS1 may change from the first curvature to the second curvature. At a first boundary between the first corner section CS1 and the first side surface SS1, the curvature of the first corner section CS1 may correspond to the first curvature. At a second boundary between the first corner section CS1 and the second side surface SS2, the curvature of the first corner section CS1 may correspond to the second curvature. Between the first boundary and the second boundary, the curvature of the first corner section CS1 may correspond to a curvature between the first and second curvatures. The foregoing description on the first corner section CS1 may also be applied to the second to fourth corner sections CS2, CS3 and CS4. However, the present disclosure is not limited thereto. The first and second curvatures may be the same, and the entire of the first corner section CS1 may have the same curvature.

Pixels may be disposed at the corner sections CS as well as the front surface FS and the side surfaces SS of the display device 10, and images can be displayed at the corner sections CS. Accordingly, when a user views the display device 10 from the front, the user can recognize that images are displayed on the entire areas of the display device 10. In other words, the user may recognize as if there is substantially no bezel and can experience more immersive contents.

No image may be displayed in the non-display area NDA. The non-display area NDA may include no pixels or emission areas. In the non-display area NDA, signal lines or a scan driver for driving the pixels or the emission areas may be disposed. The non-display area NDA may surround the display area DA. The non-display area NDA may be disposed outside the front surface FS and side surfaces SS and outside the corner sections CS. The non-display area NDA may form the bezel of the display device 10.

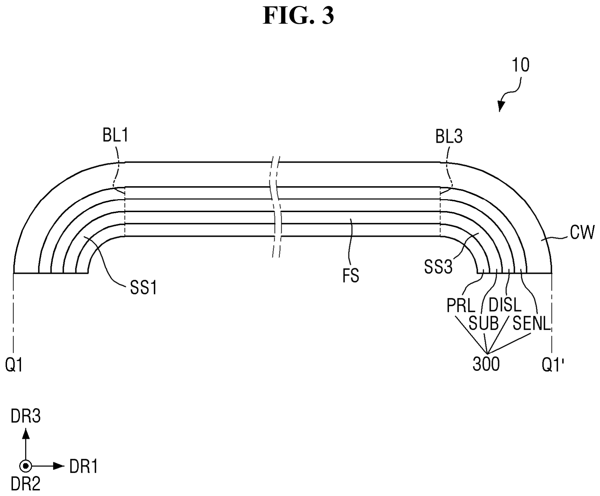

FIG. 3 is a cross-sectional view showing an example of the display panel taken along line Q1 - Q1' of FIG. 2.

Referring to FIG. 3, the display device 10 may include a protective layer PRL, a substrate SUB, a display layer DISL, a sensor layer SENL, and/or a cover window CW.

The substrate SUB may be made of an insulating material such as a polymer resin and glass. For example, the substrate SUB may include polyimide. In such case, the substrate SUB may be a flexible substrate that can be bent, folded, or rolled. The substrate SUB may provide a space in which other elements disposed thereon can be positioned, and may support the other elements disposed thereon.

The display layer DISL may be disposed on the substrate SUB. The display layer DISL may include the display area DA and the non-display area NDA. In addition to the emission areas, scan lines, data lines, power lines, etc. for driving light-emitting elements may be disposed in the display area DA of the display layer DISL. In the non-display area NDA of the display layer DISL, a scan driver circuit outputting scan signals to the scan lines, fan-out lines connecting the data lines with a driver circuit, etc. may be disposed.

The display layer DISL may include a pixel circuit layer in which thin-film transistors to be described later are formed, an emission material layer in which light-emitting elements emitting lights are disposed in the emission areas, and an encapsulation layer for encapsulating the emission material layer.

The sensor layer SENL may be disposed on the display layer DISL. The sensor layer SENL may include sensor electrodes. The sensor layer SENL can sense whether there is a touch of a person or an object using the sensor electrodes.

The cover window CW may be disposed on the sensor layer SENL. The cover window CW may be attached on the sensor layer SENL by a transparent adhesive such as optically clear adhesive (OCA) and optically clear resin (OCR). The cover window CW may be either an inorganic material such as glass or an organic material such as plastic and polymer material. The cover window CW may include the front surface FS, the side surfaces SS: SS1, SS2, SS3 and SS4, and the corner sections CS: CS1, CS2, CS3 and CS4. In some embodiments, the cover window CW may cover the display layer DISL, without being disposed on the bonding area BON. In some embodiments, the cover window CW may cover the entire area of the display layer DISL, without cover any region of the bonding area BON.

The protection member PRL can protect the lower surface of the display panel 300 from the outside and can maintain the shape of the display panel 300. In some embodiments, the protection member PRL may be a rigid layer to prevent the shape of the display panel 300 from being distorted in a manufacturing process of the display device 10.

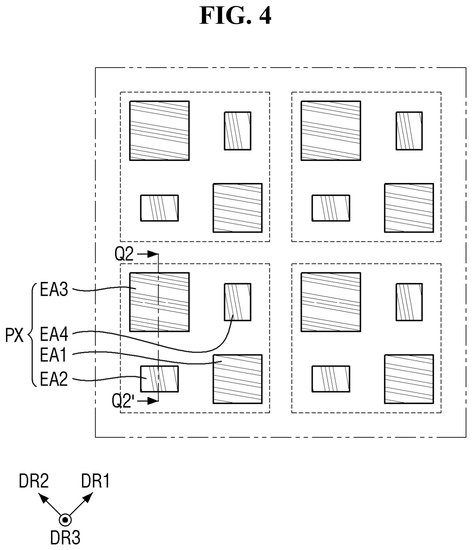

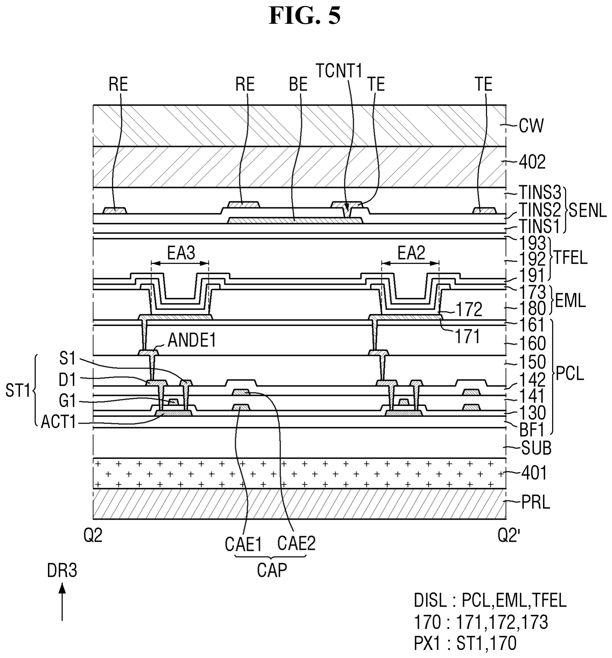

FIG. 4 is a plan view schematically showing pixels of the display area of the display device according to the embodiment. FIG. 5 is a cross-sectional view taken along line Q2 - Q2' of FIG. 4.

Referring to FIG. 4, the display area DA of the display panel 300 may include a plurality of pixels PX. Each of the pixels PX may include a plurality of emission areas EA1, EA2, EA3 and EA4. For example, each of the pixels PX may include a first emission area EA1, a second emission area EA2, a third emission area EA3, and a fourth emission area EA4. The first emission area EA1, the second emission area EA2, the third emission area EA3 and the fourth emission area EA4 may emit lights of different colors. It should be understood, however, that the present disclosure is not limited thereto. For example, the first emission area EA1 may emit light of red color, the third emission area EA3 may emit light of blue color, and the second emission area EA2 and the fourth emission area EA4 may emit light of green color.

The cross-sectional structure of a pixel PX will be described with reference to FIG. 5. A first coupling layer 401 may be disposed on the protection member PRL, and the substrate SUB may be disposed on the first coupling layer 401. The display layer DISL including the pixel circuit layer PCL, the emission material layer EML and the encapsulation layer TFEL may be disposed on the substrate SUB, and the sensor layer SENL including the driving electrodes TE, the sensing electrodes RE and the touch bridge electrodes BE may be disposed on the display layer DISL.

The protection member PRL can protect the lower surface of the display panel 300 from the outside and can help maintaining the shape of the display panel 300. In some embodiments, the protection member PRL may serve to maintain the shape of the display panel 300 in a manufacturing process of the display device 10.

The first coupling layer 401 may adhere the protection member PRL to other elements. Accordingly, the first coupling layer 401 may be made of a material that can adhere to the protection member PRL, and the lower surface of the first coupling layer 401 may be in direct contact with the upper surface of the protection member PRL to be attached to the upper surface of the protection member layer PRL. The first coupling layer 401 may be an adhesive layer or a detachable layer. The first coupling layer 401 may include, but is not limited to, an optically clear material made of silicon, such as silicon-based optically clear adhesive (OCA).

The substrate SUB may include a flexible substrate that can be bent, folded, rolled and/or stretched as described above.

The pixel circuit layer PCL may be disposed on the substrate SUB. The pixel circuit layer PCL may include first thin-film transistors ST1. The pixel circuit layer PCL may include a first thin-film transistor ST1, a pixel connection electrode ANDE1, a buffer layer BF1, a gate insulator 130, a first interlayer dielectric layer 141, a second interlayer dielectric layer 142, a first planarization layer 150, and a second planarization layer 160.

The buffer layer BF1 may be disposed on the substrate SUB. The buffer layer BF1 may be formed of a silicon nitride layer, a silicon oxynitride layer, a silicon oxide layer, a titanium oxide layer, or an aluminium oxide layer.

The first thin-film transistor ST1 may be disposed on the buffer layer BF1. The first thin-film transistor ST1 may include a first active layer ACT1, a first gate electrode G1, a first source electrode S1, and a first drain electrode D1.

The first active layer ACT1 of the first thin-film transistor ST1 may be disposed on the buffer layer BF1. The first active layer ACT1 may include silicon semiconductor such as polycrystalline silicon, monocrystalline silicon, low-temperature polycrystalline silicon and amorphous silicon. The part of the first active layer ACT1 overlapping the first gate electrode G1 in the third direction DR3 may be defined as a channel region. Another part of the first active layer ACT1 not overlapping the first gate electrode G1 in the third direction DR3 may be defined as a conductive region. The conductive regions of the first active layer ACT1 may have conductivity by doping a silicon semiconductor with ions or impurities.

The gate insulator 130 may be disposed on the first active layer ACT1 of the first thin-film transistor ST1. The gate insulator 130 may be formed of an inorganic layer, for example, a silicon nitride layer, a silicon oxynitride layer, a silicon oxide layer, a titanium oxide layer, or an aluminium oxide layer.

The first gate electrode G1 of the first thin-film transistor ST1 and a first capacitor electrode CAE1 may be disposed on the gate insulator 130. The first gate electrode G1 of the first thin-film transistor ST1 may overlap the first active layer ACT1 in the third direction DR3. The first capacitor electrode CAE1 may overlap the second capacitor electrode CAE2 in the third direction (z-axis direction). The first gate electrode G1 and the capacitor electrode CAE1 may be made up of a single layer or multiple layers of one of molybdenum (Mo), aluminium (Al), chromium (Cr), gold (Au), titanium (Ti), nickel (Ni), neodymium (Nd) and copper (Cu) or an alloy thereof.

The first interlayer dielectric layer 141 may be disposed on the first gate electrode G1 and the first capacitor electrode CAE1. The first interlayer dielectric layer 141 may be formed of an inorganic layer, for example, a silicon nitride layer, a silicon oxynitride layer, a silicon oxide layer, a titanium oxide layer, or an aluminium oxide layer. The first interlayer dielectric layer 141 may include a number of inorganic layers.

The second capacitor electrode CAE2 may be disposed on the first interlayer dielectric layer 141. The second capacitor electrode CAE2 may overlap the first capacitor electrode CAE1 in the third direction DR3. Since the first interlayer dielectric layer 141 has a predetermined dielectric constant, a capacitor can be formed by the first capacitor electrode CAE1, the second capacitor electrode CAE2 and the first interlayer dielectric layer 141. The second capacitor electrode CAE2 may be made up of a single layer or multiple layers of one of molybdenum (Mo), aluminium (Al), chromium (Cr), gold (Au), titanium (Ti), nickel (Ni), neodymium (Nd) and copper (Cu) or an alloy thereof.

A second interlayer dielectric layer 142 may be disposed over the second capacitor electrode CAE2. The second interlayer dielectric layer 142 may be formed of an inorganic layer, for example, a silicon nitride layer, a silicon oxynitride layer, a silicon oxide layer, a titanium oxide layer, or an aluminium oxide layer.

The first source electrode S1 and the first drain electrode D1 of the first thin-film transistor ST1 may be disposed on the second interlayer dielectric layer 142. The first source electrode S1 and the first drain electrode D1 may be made up of a single layer of one of molybdenum (Mo), aluminium (Al), chromium (Cr), gold (Au), titanium (Ti), nickel (Ni), neodymium (Nd) and copper (Cu) or an alloy thereof, or multiple layers thereof.

The first source electrode S1 of the first thin-film transistor ST1 may be connected to the conductive region located on a side of the channel region of the first active layer ACT1 through a contact hole penetrating through the gate insulator 130, the first interlayer dielectric layer 141 and the second interlayer dielectric layer 142. The first drain electrode D1 of the first thin-film transistor ST1 may be connected to the conductive region located on the opposite side of the channel region of the first active layer ACT1 through a contact hole penetrating through the gate insulator 130, the first interlayer dielectric layer 141 and the second interlayer dielectric layer 142.

The first planarization layer 150 may be disposed on the first source electrode S1 and the first drain electrode D1 to provide a flat surface over the thin-film transistors having different levels. The first planarization layer 150 may be formed of an organic layer such as an acryl resin, an epoxy resin, a phenolic resin, a polyamide resin and a polyimide resin.

The pixel connection electrode ANDE1 may be disposed on the first planarization layer 150. The pixel connection electrode ANDE1 may be connected to the first source electrode S1 or the first drain electrode D1 of the first thin-film transistor ST1 through a contact hole penetrating the first planarization layer 150. The pixel connection electrode ANDE1 may be made up of a single layer or multiple layers of one of molybdenum (Mo), aluminium (Al), chromium (Cr), gold (Au), titanium (Ti), nickel (Ni), neodymium (Nd) and copper (Cu) or an alloy thereof.

The second planarization layer 160 may be disposed on the pixel connection electrode ANDE1. The second planarization layer 160 may be formed of an organic layer such as an acryl resin, an epoxy resin, a phenolic resin, a polyamide resin and a polyimide resin.

A barrier layer 161 may be disposed on the second planarization layer 160. The barrier layer 161 may be formed of a silicon nitride layer, a silicon oxynitride layer, a silicon oxide layer, a titanium oxide layer, or an aluminium oxide layer.

The emission material layer EML may be disposed on the pixel circuit layer PCL. The emission material layer EML may include light-emitting elements 170 and a bank 180.

Each of the light-emitting elements 170 may include a pixel electrode 171, an emissive layer 172, and a common electrode 173. In each of the emission areas EA1, EA2, EA3 and EA4, the pixel electrode 171, the emissive layer 172 and the common electrode 173 are stacked on one another sequentially, so that holes from the pixel electrode 171 and electrons from the common electrode 173 are combined with each other in the emissive layer 172 to emit light. In such case, the pixel electrode 171 may be an anode electrode while the common electrode 173 may be a cathode electrode. The first emission area EA1 and the fourth emission area EA4 may be substantially identical to the third emission area EA3.

The pixel electrode 171 may be disposed on the barrier layer 161. The pixel electrode 171 may be connected to the pixel connection electrode ANDE1 through a contact hole penetrating the barrier layer 161 and the second planarization layer 160.

In a top-emission structure in which light is emitted toward the common electrode 173 from the emissive layer 172, the pixel electrode 171 may be made up of a stack structure (ITO/AI/ITO) of ITO having a high work function, aluminium for reflecting light, and ITO with high adhesion.

The bank 180 serves to define each of the emission areas EA1, EA2, EA3 and EA4 of display pixels. To this end, the bank 180 may be formed on the barrier layer 161 to expose a part of the pixel electrode 171. The bank 180 may cover the edge of the pixel electrode 171. The bank 180 may be formed of an organic layer such as an acryl resin, an epoxy resin, a phenolic resin, a polyamide resin and a polyimide resin.

The emissive layer 172 may be disposed on the pixel electrode 171. The emissive layer 172 may include an organic material to emit light of a certain color. For example, the emissive layer 172 may include a hole transporting layer, an organic material layer, and an electron transporting layer. The organic material layer may include a host and a dopant. The organic material layer may include a material that emits a predetermined light, and may be formed using a phosphor or a fluorescent material.

The common electrode 173 may be disposed on the emissive layer 172. The common electrode 173 may cover the emissive layer 172. The common electrode 173 may be a common layer formed across the display pixels. A capping layer may be formed on the common electrode 173.

In the top-emission structure, the common electrode 173 may be thinly formed of a transparent conductive material (TCO) that can reduce resistance and transmit light such as ITO and IZO, and magnesium (Mg), silver (Ag), or an alloy of magnesium (Mg) and silver (Ag) with a low work function.

The encapsulation layer TFEL may be formed on the emission material layer EML. The encapsulation layer TFEL may include at least one inorganic layer to prevent permeation of oxygen or moisture into the emission material layer EML. In addition, the encapsulation layer TFEL may include at least one organic layer to protect the emission material layer EML from particles. In some embodiments, the encapsulation layer TFEL may include at least one inorganic layer and at least one organic layer stacked on each other.

For example, the thin-film encapsulation layer TFEL may include a first inorganic encapsulation film 191 disposed on the common electrode 173, an organic encapsulation film 192 disposed on the first inorganic encapsulation film 191, and a second inorganic encapsulation film 193 disposed on the organic encapsulation film 192. The first inorganic encapsulation film 191 and the second inorganic encapsulation film 193 may be made up of multiple films in which one or more inorganic layers of a silicon nitride layer, a silicon oxynitride layer, a silicon oxide layer, a titanium oxide layer and an aluminium oxide layer are alternately stacked on one another. The organic layer may be an acryl resin, an epoxy resin, a phenolic resin, a polyamide resin or a polyimide resin.

The sensor layer SENL is disposed on the encapsulation layer TFEL. The sensor layer SENL may include the driving electrodes TE, the sensing electrodes RE and the touch bridge electrodes BE.

A first touch inorganic layer TINS1 may be disposed on the encapsulation layer TFEL. The first touch inorganic layer TINS1 may be formed as a silicon nitride layer, a silicon oxynitride layer, a silicon oxide layer, a titanium oxide layer, or an aluminium oxide layer.

The touch bridge electrodes BE may be disposed on the first touch inorganic layer TINS1. The touch bridge electrodes BE may be formed of a stacked structure of aluminium and ITO (ITO/AI/ITO).

A second touch inorganic layer TINS2 may be disposed on the touch bridge electrodes BE. The second touch inorganic layer TINS2 may be formed as a silicon nitride layer, a silicon oxynitride layer, a silicon oxide layer, a titanium oxide layer, or an aluminium oxide layer.

The driving electrodes TE and the sensing electrodes RE may be disposed on the second touch inorganic layer TINS2. In order to prevent the light emitted from the emission areas EA1, EA2, EA3 and EA4 from being blocked by the driving electrodes TE and the sensing electrodes RE to thereby decrease the luminance of the light, the driving electrodes TE and the sensor electrodes RE do not overlap the emission areas EA1, EA2, EA3 and EA4. The driving electrodes TE and the sensing electrodes RE may be formed of a stack structure of aluminium and titanium (Ti/Al/Ti).

A touch organic layer TINS3 may be disposed on the driving electrodes TE and the sensing electrodes RE. The touch organic layer TINS3 may be an acryl resin, an epoxy resin, a phenolic resin, a polyamide resin and a polyimide resin.

The cover window CW may be disposed on the display panel 300. The cover window CW may be attached to the display panel 300 through a second coupling layer 402 disposed between the display panel 300 and the cover window CW. The second coupling layer 402 may include an acrylic optically clear adhesive (OCA). Accordingly, the second coupling layer 402 may be optically clear. The upper surface of the second coupling layer 402 may be in direct contact with the lower surface of the cover window CW and may have the same area and shape as the lower surface of the cover window CW.

The protection member PRL may be disposed on the rear side of the display panel 300. The protection member PRL may overlap the display area DA of the display panel 300 to protect the lower surface of the display panel 300 from the outside and can maintain the shape of the display panel 300.

As described above, the display device 10 may include the side surfaces and the corner sections having curvatures. The corner sections of the display device 10 may have a double curvature having both the curvatures of the left and right side surfaces and the curvatures of the upper and lower side surfaces, and accordingly such shape of the display device 10 may necessitate strain (i.e., deformation) on the protection member PRL and the display layer DISL. For example, in a process of attaching the protection member PRL to the display layer DISL, the protection member PRL and the display layer DISL may be deformed to be aligned with each other at the corner sections with the double curvature. In such deformation of the protection member PRL, wrinkles may be formed on the deformed surface of the protection member PRL. During the process of attaching the display panel 300 to the protection member PRL, heat is applied to remove such wrinkles. Due to a difference in elastic modulus and contraction rate between the protection member PRL and the display panel 300, the protection member PRL may be detached from the display panel 300, such that bubbles are generated, i.e., buckling may occur. If buckling occurs in the protection member PRL, cracks may be generated in the display panel 300 and lines may be disconnected. As a result, display defects may occur.

According to the embodiment of the present disclosure, the protection member PRL may include a material having elasticity, so that strain concentrated at the corner sections can be relieved. The protection member PRL may include a material that contracts in a particular temperature environment so that it can be easily attached to the side surfaces and the corner sections of the display device 10 that have curvatures. For example, the protection member PRL may include one of polyolefin-based, polyvinyl-based, polyethylene-based, and polyester-based resins. The protection member PRL may include a stretched polyester, for example, polyethylene terephthalate (PET).

The protection member PRL may have a predetermined thickness to support and protect the display panel 300. The protection member PRL may have a thickness of 100 µm or less, for example, 25 µm to 100 µm.

When heat is applied to the protection member PRL, the protection member PRL may contract. The protection member PRL may have a contraction rate of 20% or more in a temperature range of 50 degrees to 150 degrees Celsius. For example, the protection member PRL may exhibit a contraction rate of 30% or more when heat is applied at the temperature of 85 degrees Celsius for about ten minutes. If the protection member PRL has a contraction rate less than 20% in the temperature range of 50 to 150 degrees Celsius, there may be curves at the corner sections of the display device 10, resulting in buckling between the display device 10 and the protection member PRL. Accordingly, the protection member PRL preferably has a contraction rate of 20% or more, more preferably 30% or more, in the temperature range of 50 to 150 degrees Celsius to prevent buckling. In some embodiments, the protection member PRL may have a contraction rate of 30% or more in the temperature range of 50 to 150 degrees Celsius to remove or straighten the wrinkles caused by the buckling more efficiently.

The protection member PRL contracts along with other layers attached to the upper or lower surfaces of the protection member PRL. In addition, when the protection member PRL contracts, the distance between molecules in the contracted portion decreases. Therefore, the distance between molecules in the contracted portion of the protection member PRL may be smaller than the distance between molecules in the non-contracted portion of the protection member PRL. Accordingly, the protection member PRL that has contracted by receiving heat may have a higher density per unit volume than the protection member PRL that has not contracted by not receiving heat.

In addition, the protection member PRL may have a glass transition temperature (Tg) in the range of 50 degrees to 150 degrees Celsius. The protection member PRL may have an elastic modulus of 4 GPa or less in range of the glass transition temperature (Tg), for example, a temperature range of 50 to 150 degrees Celsius. If the elastic modulus of the protection member PRL is equal to or less than 4 GPa, it has flexibility when heat is applied to the protection member PRL. Accordingly, it is possible to prevent curves at the corner sections of the display device 10 due to the double-curvatures and to prevent adhesion failure. In some embodiments, the protection member PRL may have the elastic modulus of 3.6 GPa at room temperature (25 degrees Celsius). In some embodiments, the protection member PRL may exhibit a glass transition temperature of 74 to 78 degrees Celsius, and may have an elastic modulus of 2.5 GPa or less, preferably 0.6 to 0.9 GPa in the temperature range of 74 to 78 degrees Celsius.

Accordingly, the protection member PRL according to the embodiment may satisfy the following characteristic conditions:
1) glass transition temperature: 50 to 150 degrees Celsius
2) elastic modulus: 4 GPa or less (temperature in the range of 50 to 150 degrees Celsius)
3) contraction rate: 20% or more (temperature in the range of 50 to 150 degrees Celsius)

As described above, according to the embodiment, by using the protection member PRL that satisfies the above-described characteristic conditions, it is possible to prevent that bubbles are generated due to adhesion failure, i.e., buckling, and to improve the issues of cracks and disconnection in the display panel 300.

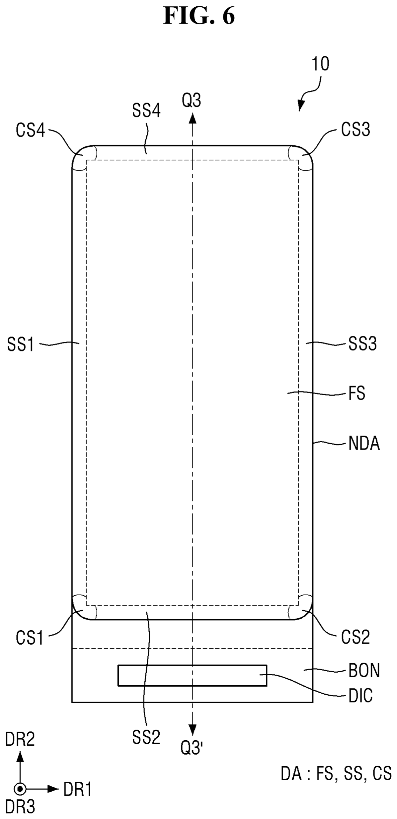

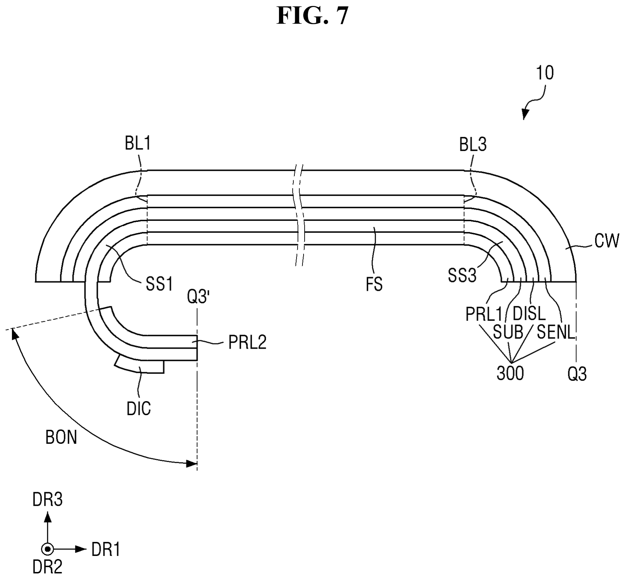

FIG. 6 is a plan view showing a display panel of a display device according to another embodiment of the present disclosure. FIG. 7 is a cross-sectional view taken along line Q3 - Q3' of FIG. 6.

The embodiment of FIGS. 6 and 7 is different from the embodiment of FIGS. 1 to 5 in that a first protection member PRL1 is disposed in a display area DA of a display panel 300, and a second protection member PRL2 is disposed in a bonding area BON of the display panel 300.

The display device 10 according to the embodiment may include a display panel 300. The display panel 300 may include the display area DA and the bonding area BON. The bonding area BON may be spaced apart from the display area DA and may be located on a substrate SUB extended from the display area DA. The bonding area BON may be located on the rear surface of the display area DA as the flexible substrate SUB is bent. The bonding area BON may include a driver circuit DIC. The driver circuit DIC may transfer a driving signal from an external device to the display area DA.

The first protection member PRL1 overlapping the display area DA and the second protection member PRL2 overlapping the bonding area BON may be disposed on the rear side of the substrate SUB. The first protection member PRL1 and the second protection member PRL2 may be spaced apart from each other. The first protection member PRL1 may support the display area DA to protect the lower surface of the display panel 300 from the outside, and the second protection member PRL2 may support the bonding area BON to protect lower surface of the bonding area BON from the outside.

The first protection member PRL2 may be the protection member PRL described above with reference to FIGS. 1 to 5. The second protection member PRL2 may include a resin having heat resistance. For example, the second protection member PRL2 may include a polyester-based resin or a polyimide-based resin. The polyester-based resin may include polyethylene terephthalate (PET).

The driver circuit DIC may be mounted on the bonding area BON of the substrate SUB via a pressing process. Since heat is applied to the bonding area BON in the pressing process, the second protection member PRL2 can have heat resistance so that it is not damaged by heat. When the second protection member PRL2 is damaged by heat, the driver circuit DIC and the terminals in the bonding area BON may be misaligned, and accordingly driving failure may occur.

According to the embodiment of the present disclosure, the second protection member PRL2 can have heat resistance and a low coefficient of thermal expansion (CTE). The coefficient of thermal expansion of the second protection member PRL2 may be equal to or less than 30 ppm/°C at a temperature ranging from room temperature to 180 degrees Celsius. In some embodiments, the coefficient of thermal expansion of the second protection member PRL2 may be equal to or less than 30 ppm/°C at a temperature selected from a range from the room temperature to the melting temperature of a material of the second protection member PRL2. The lower the coefficient of thermal expansion is, the smaller the volume changes as the temperature increases. Since the second protection member PRL2 has a low coefficient of thermal expansion of 30 ppm/°C or less, it is possible to prevent deformation due to heat during the process of pressing the driver circuit DIC, thereby preventing the misalignment of the driver circuit DIC.

The melting point of the second protection member PRL2 may be equal to or greater than 180 degrees Celsius. The melting point of a substance is the temperature at which it changes state from solid to liquid. The higher the melting point of a substance is, the stronger its heat resistance is. Since the second protection member PRL2 has a melting point of 180 degrees Celsius or higher, it is possible to prevent the second protection member PRL2 from being damaged by heat during the pressing process of the driver circuit DIC.

The second protection member PRL2 may have a smaller contraction rate than the first protection member PRL1. According to the embodiment of the present disclosure, the contraction rate of the second protection member PRL2 may be equal to or less than 1% in the temperature range of 50 to 150 degrees Celsius. The first protection member PRL1 should have a high contraction rate in order to be reliably attached to the lower surface of the substrate SUB, e.g., the side surfaces and the corner sections having curvatures. On the contrary, the second protection member PRL2 should have a low contraction rate in order to withstand heat applied during the process of pressing the driver circuit DIC while being attached to the lower surface of the substrate SUB and to prevent misalignment between the driver circuit DIC and the terminals

Specifically, when the second protection member PRL2 contracts, other layers attached to the upper surface of the second protection member PRL2 may also contract. In this instance, during the above-described process of pressing the driver circuit DIC, the substrate SUB contracts along with the second protection member PRL2, so that the driving circuit DIC and the terminals of the substrate SUB may be misaligned. The second protection member PRL2 has a contraction rate of 1% or less in the temperature range of 50 to 150 degrees Celsius, it is possible to prevent misalignment between the driver circuit DIC and the terminals of the substrate SUB during the process of pressing the driver circuit DIC. For example, the amount of contraction of the second protection member PRL2 with the contraction rate of 1% or less may be allowable within a process margin in which the driver circuit DIC is aligned to the terminals of the substrate SUB.

The second protection member PRL2 may have a larger elastic modulus than the first protection member PRL1. The larger the elastic modulus is, the less the strain may be even if the tensile stress increases. That is to say, as the elastic modulus increases, the protection member may become harder. The second protection member PRL2 may have a high elastic modulus in order to prevent misalignment between terminals of the substrate SUB disposed thereon and the driver circuit DIC.

According to an embodiment of the present disclosure, the second protection member PRL2 may have an elastic modulus of 4.5 GPa or higher at a process temperature, e.g., a temperature range of 50 to 150 degrees Celsius. In some embodiments, the elastic modulus of the second protection member PRL2 may range from 4.5 to 5.5 GPa. If the elastic modulus of the second protection member PRL2 is equal to or greater than 4.5 GPa, the strain (or deformation) of the second protection member PRL2 can be reduced, and the deformation of the substrate SUB attached to the second protection member PRL2 may also be reduced. Accordingly, it is possible to prevent misalignment between the terminals formed on the substrate SUB and the driver circuit DIC, and thus driving defects can be prevented.

Accordingly, the second protection member PRL2 according to the embodiment may satisfy the following characteristic conditions:
1) coefficient of thermal expansion: 30 ppm/°C or less (temperature in the range of room temperature to 180 degrees Celsius)
2) elastic modulus: 4.5 GPa or more (temperature in the range of 50 to 150 degrees Celsius)
3) contraction rate: 1% or less (temperature in the range of 50 to 150 degrees Celsius)
4) melting point: 180°C or higher

As described above, according to the embodiment, by using the second protection member PRL2 satisfying the above-described characteristic conditions, it is possible to prevent the misalignment between the driver circuit DIC and the terminals in the bonding area BON during the process of bonding the driver circuit DIC, to improve driving defects.

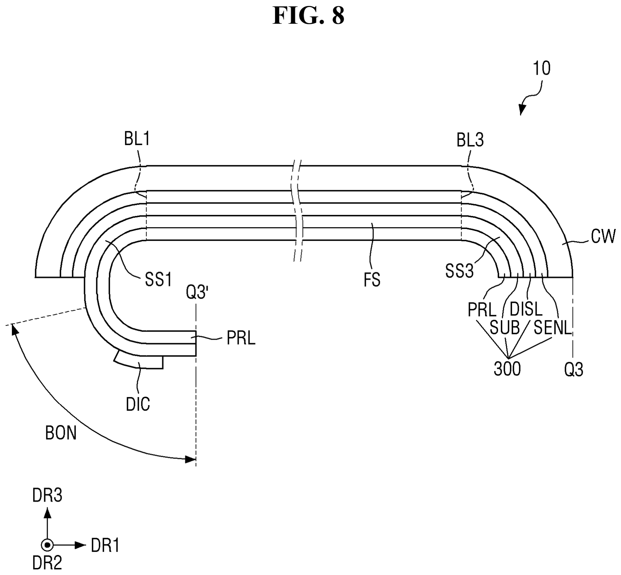

FIG. 8 is a cross-sectional view showing another example, taken along line Q3 - Q3' of FIG. 6.

The embodiment of FIG. 8 is different from the embodiments of FIGS. 1 to 7 in that a single protection member PRL is disposed on the rear side of a display area DA and a bonding area BON of a display panel 300.

The display device 10 according to the embodiment may include a protection member PRL overlapping the display area DA and the bonding area BON on the rear side of the substrate SUB of the display panel 300. The protection member PRL may be extended from the display area DA of the display panel 300 to the bonding area BON. The protection member PRL can support the display area DA and the bonding area BON and can protect the lower surface of the display panel 300 from the outside.

As described above, the protection member PRL used in the display area DA requires a low coefficient of thermal expansion and a low modulus, while the protection member PRL used in the bonding area BON requires a low coefficient of thermal expansion and a high melting point. According to this embodiment, the display device 10 is fabricated using a low-temperature process in which the bonding process temperature of the driver circuit IC is equal to or less than 50 degrees Celsius.

According to the embodiment of the present disclosure, the single protection member PRL is disposed on the rear side of the display panel 300 to simplify the structure and process, and the protection member PRL may satisfy the following characteristics:
1) coefficient of thermal expansion: 30ppm/°C or less (temperature in the range of room temperature to 180 degrees Celsius)
2) elastic modulus: 2.5 GPa or less (temperature in the range of 50 to 150 degrees Celsius)
3) contraction rate: 20% or more (temperature in the range of 50 to 150 degrees Celsius)
4) melting point: 180°C or higher

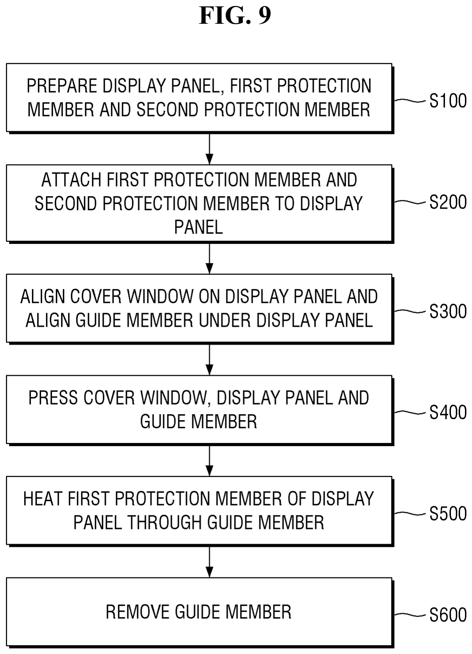

FIG. 9 is a flowchart for illustrating a method for fabricating a display device according to an embodiment of the present disclosure.

Referring to FIG. 9, the method of fabricating a display device 10 may include providing a display panel 300, a first protection member PRL1 and a second protection member PRL2 (step S100); attaching the first protection member PRL1 and the second protection member PRL2 to the display panel 300 (step S200); aligning a cover window CW on the display panel 300 and aligning a guide member HG under the display panel 300 (step S300); pressing the cover window CW, the display panel 300 and the guide member HG (step S400); heating the first protection member PRL1 of the display panel 300 through the guide member HG (step S500); and removing the guide member HG (step S600).

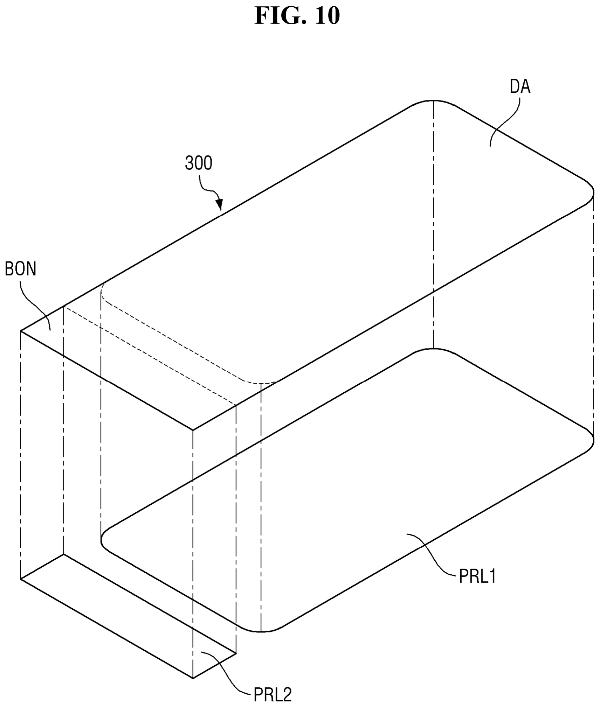

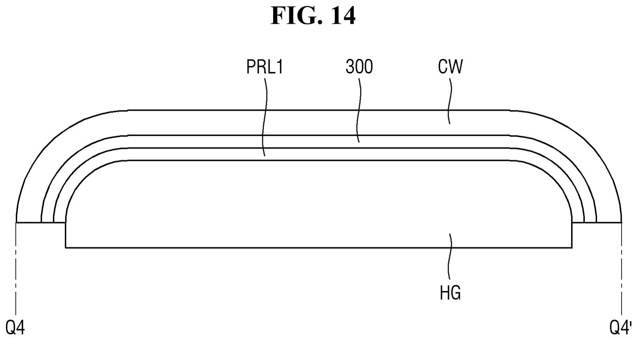

FIGS. 10 to 17 are views showing processing steps of a method of fabricating a display device according to an embodiment of the present disclosure.

Hereinafter, a method of fabricating a display device 10 will be described in detail with reference to FIGS. 10 to 17 in conjunction with the flowchart of FIG. 9.

Referring to FIG. 10, a display panel 300, a first protection member PRL1 and a second protection member PRL2 are prepared (step S100). The first protection member PRL1 and the second protection member PRL2 may be aligned on the rear side of the display panel 300.

The first protection member PRL1 may be the protection member PRL described above with reference to FIGS. 1 to 5, and the second protection member PRL2 may be the second protection member PRL2 described above with reference to FIGS. 6 and 7. For example, the first protection member PRL1 may have a contraction rate of 20% or more in a temperature range of 50 to 150 degrees Celsius, may exhibit a glass transition temperature (Tg) of 50 to 150 degrees Celsius, and may have an elastic modulus of 4 GPa or less in a temperature range of 50 to 150 degrees Celsius. In addition, the second protection member PRL2 may have a coefficient of thermal expansion of 30 ppm/°C or less at room temperature to 180 degrees Celsius, may have a melting point of 180 degrees Celsius or more, and may have the contraction rate of 1% or less in a temperature range of 50 to 150 degrees Celsius. In some embodiments, the second protection member PRL2 may have a coefficient of thermal expansion of 30 ppm/°C or less at a temperature selected from a range of the room temperature to the melting point, and may have the contraction rate of 1% or less at a first temperature selected from a temperature range of 50 to 150 degrees Celsius. In some embodiments, the first temperature selected from the temperature range may correspond to a glass transition temperature of the second protection member PRL2.

Subsequently, the first protection member PRL1 and the second protection member PRL2 are attached to the display panel 300 (step S200). The first protection member PRL1 may be attached to the rear side of the display area DA of the display panel 300, and the second protection member PRL2 may be attached to the rear side of the bonding area BON of the display panel 300. The adhesion between the first protection member PRL1 and the display panel 300 may be preliminary bonding. They may be completely bonded during a bonding process described later. A first coupling layer may be disposed on the upper surface of each of the first protection member PRL1 and the second protection member PRL2, so that the first protection member PRL1 and the second protection member PRL2 may be attached to the rear side of the display panel 300. The first coupling layer may be, for example, a pressure sensitive adhesive (PSA).

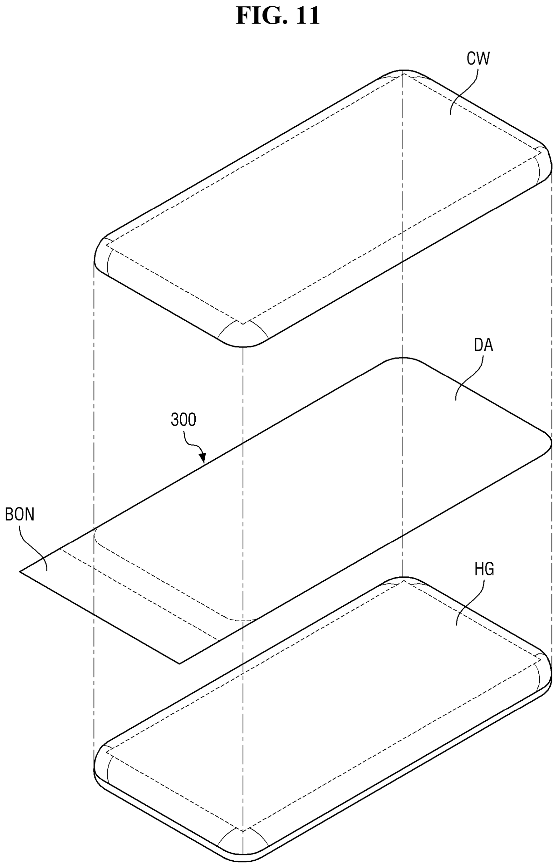

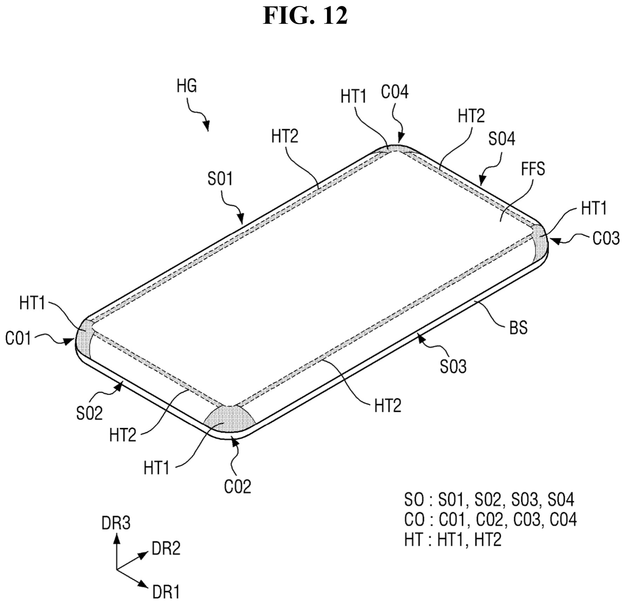

Subsequently, referring to FIGS. 11 and 12, a cover window CW is aligned on the display panel 300, and a guide member HG is aligned under the display panel 300 (step S300). The cover window CW and the display panel 300 have been described above and accordingly will not be described to avoid redundancy. For example, the cover window CW may have the front surface FS, the side surfaces SS and the corner sections CS described above with reference to FIG. 2. In some embodiments, the cover window CW may be aligned to an upper surface of the display area DA and the guide member HG may be aligned to a lower surface of the display area DA, and thus the cover window CW and the guide member HG may be pressed against the display area DA. In some embodiments, the cover window CW and the guide member HG may not cover upper and lower surfaces of the bonding area BON, respectively.

As shown in FIG. 12, the guide member HG may have a shape similar to that of the cover window CW. Specifically, the guide member HG may include a base BS, a flat portion FFS, curved portions SO: SO1, SO2, SO3 and SO4, and double-curved portions CO: CO1, CO2, CO3 and CO4. In some embodiments, the guide member HG may have the substantially the same shape as that of the cover window CW, and the dimension of the guide member HG may be smaller than that of cover window CW so that the guide member HG may fit into a space defined by an inner surface of the cover window CW with the display panel 300 therebetween in a pressed status of the cover window CW, the guide member HG, and the display panel 300.

The base BS may correspond to a body serving as a base for the flat portion FFS, the curved portions SO, and the double-curved portions CO. The base BS may form the bottom of the guide member HG.

The flat portion FFS may be a substantially flat area and may be associated with the front surface of the cover window CW. The flat portion FFS may include a rectangular shape having shorter sides in the first direction DR1 and longer sides in the second direction DR2. The flat portion FFS may have round corners when viewed from the top.

The curved portions SO: SO1, SO2, SO3 and SO4 may be extended outward from the edges of the flat portion FFS to be bent at a predetermined angle. When the front portions FFS has a rectangular shape when viewed from the top, the curved portions SO may include a first curved portion SO1 and a third curved portion SO3 extended from the front portion FFS toward one side and the opposite side in the first direction DR1, respectively, and may include a second curved portion SO2 and a fourth curved portion SO4 extended toward one side and the opposite side in the second direction DR2, respectively. The first to fourth curved portions SO1, SO2, SO3 and SO4 may be associated with the first to fourth side surfaces SS1, SS2, SS3 and SS4 of the cover window CW, respectively. The first to fourth curved portions SO1, SO2, SO3 and SO4 may be extended from the front portion FFS to have predetermined curvatures and may have a round shape.

The portions that are curved outward from the flat portion FFS of the guide member HG between adjacent curved portions SS: SS1, SS2, SS3 and SS4 are defined as the double curved portions CO. The first to fourth curved portions SO1, SO2, SO3 and SO4 may be spaced apart from each other with a predetermined distance at at least some positions. The double-curved portions CO: CO1, CO2, CO3 and CO4 may be located at the positions where the first to fourth curved portions SO1, SO2, SO3 and SO4 are spaced apart from each other.

For example, a first double-curved portion CO1 may be disposed between the first curved portion SO1 and the second curved portion SO2, a second double-curved portion CO2 may be disposed between the second curved portion SO2 and the third curved portion SO3, a third double-curved portion CO3 may be disposed between the third curved portion SO3 and the fourth curved portion SO4, and a fourth double-curved portion CO4 may be disposed between the fourth curved portion SO4 and the first curved portion SO1. The first to fourth double-curved portions CO1, CO2, CO3 and CO4 may be associated with the corner sections CS: CS1, CS2, CS3 and CS4 of the cover window CW, respectively.

The first to fourth double-curved portions CO1, CO2, CO3 and CO4 may include double-curvatures including the curvatures of the adjacent curved portions SO and may have a round shape. For example, the first double curved portion CO1 may be located between the first curved portion SO1 and the second curved portion SO2. In this instance, the first double-curved portion CO1 may have a double curvature including the first curvature of the first curved portion SO1 and the second curvature of the second curved portion SO2. For example, a curvature of the first double-curved portion CO1 may change from the first curvature to the second curvature. At a first boundary between the first double-curved portion CO1 and the first curved portion SO1, the curvature of the first double-curved portion CO1 may correspond to the first curvature. At a second boundary between the first double-curved portion CO1 and the second curved portion SO2, the curvature of the first double-curved portion CO1 may correspond to the second curvature. Between the first boundary and the second boundary, the curvature of the first double-curved portion CO1 may correspond to a curvature between the first and second curvatures.

The guide member HG as described above has a shape similar to that of the cover window CW, and as will be described later, presses the display panel 300 from below to reliably attach the first protection member PRL1 to the rear surface of the display panel 300.

The guide member HG may further include heaters HT. The heaters HT are for dissipating heat, and may include components that dissipate heat such as a coil and an infrared irradiation device. The heaters HT may be disposed at the curved portions SO and the double-curved portions CO of the guide member HG.

Specifically, the heaters HT may include first heaters HT1 disposed at the double-curved portions CO, and second heaters HT2 disposed at at least a part of the curved portions SO. The first heaters HT1 may be disposed at the double-curved portions CO, respectively. For example, the first heaters HT1 may be disposed at the first to fourth double-curved portions CO1, CO2, CO3 and CO4, respectively. The area of the first heaters HT1 may be equal to the area of each of the first to fourth curved portions CO1, CO2, CO3 and CO4, but the present disclosure is not limited thereto. The area of the first heaters HT1 may be larger or smaller than the area of each of the first to fourth curved portions CO1, CO2, CO3 and CO4. The second heaters HT2 may be disposed at the curved portions SO, respectively. The second heaters HT2 may be disposed at at least a part of the curved portions SO. For example, the second heaters HT2 may be disposed where the first to fourth curved portions SO1, SO2, SO3 and SO4 and the flat portions FFS meet. The second heaters HT2 may be arranged in a shape that entirely surrounds the flat portion FFS.

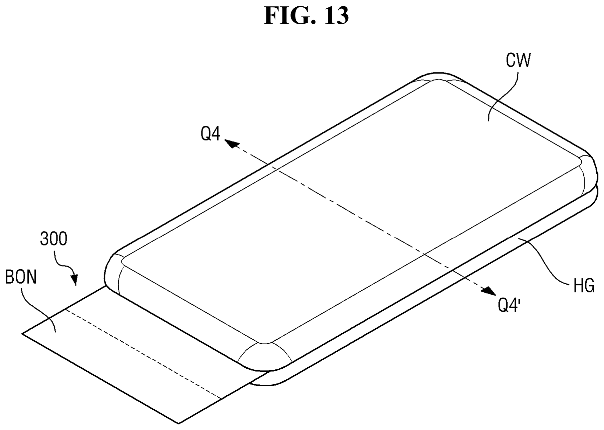

Subsequently, referring to FIGS. 13 to 15, the cover window CW, the display panel 300 and the guide member HG are pressed (step S400). Specifically, the cover window CW may press against the display panel 300 on the front side of the display panel 300, and the guide member HG may press against the display panel 300 on the rear side of the display panel 300.

When the cover window CW and the guide member HG are pressed above and below the display panel 300, the display panel 300 may be attached to the lower surface of the cover window CW conforming to the shape of the cover window CW. In this instance, the lower surface of the cover window CW may be applied with a pressure-sensitive adhesive (PSA), and the upper surface of the display panel 300 and the lower surface of the cover window CW may be attached together by the pressure-sensitive adhesive (PSA). As described above, the cover window CW may include the front surface FS, the side surfaces SS: SS1, SS2, SS3 and SS4, and the corner sections CS: CS1, CS2, CS3 and CS4, and the flat display panel 300 may be closely attached to the front surface FS, the side surfaces SS, and the corner sections CS of the cover window CW.

In addition, when the guide member HG presses the rear side of the display panel 300, the first protection member PRL1 adhered to the lower surface of the display panel 300 may receive strain at the side surfaces SS and corner sections CS of the cover window CW having the curvatures. Accordingly, the first protection member PRL1 may be strained, that is, deformed. For example, when being pressed between the cover window CW and the guide member HG, the first protection member PRL1 may be deformed along the shapes of the side surfaces SS of the cover window CW and corner sections CS thereof. The deformation of the first protection member PRL1 on the corner sections CS may cause the first protection member PRL1 to buckle, which may result in wrinkles on the deformed surface of the first protection member PRL1 at the corner sections CS. According to this embodiment, it is possible to eliminate deformation of the first protection member PRL1 by heating of the guide member HG, which will be described later.

Subsequently, the first protection member PRL1 of the display panel 300 is heated through the guide member HG (step S500). In this step, heat may be applied to the first protection member PRL1 by the heating of the guide member HG and thus it contracts.

Specifically, the temperature of the first protection member PRL1 may be increased by applying heat from the heaters HT of the guide member HG. The heaters HT may apply heat in a temperature range of approximately 50 to 150 degrees Celsius. As described above, the first protection member PRL1 has a contraction rate of 20% or more in the temperature range of 50 to 150 degrees Celsius, so that it may contract as the temperature rises. Since the first protection member PRL1 is coupled to the display panel 300 by the coupling layer, when the first protection member PRL1 contracts, the display panel 300 coupled thereto also contracts, and thus the corner sections CS of the display device 10, i.e., the corners of cover window CW may entirely contract.

Since the side surfaces of the display device 10 adjacent to the corner sections are bent downward after the above-described pressing step, the corner sections may contract such that the distance between the molecules of the first protection member PRL1 decreases. Accordingly, the corner sections may contract in the same direction as the center direction between the directions in which adjacent side surfaces of the display device 10 are curved.

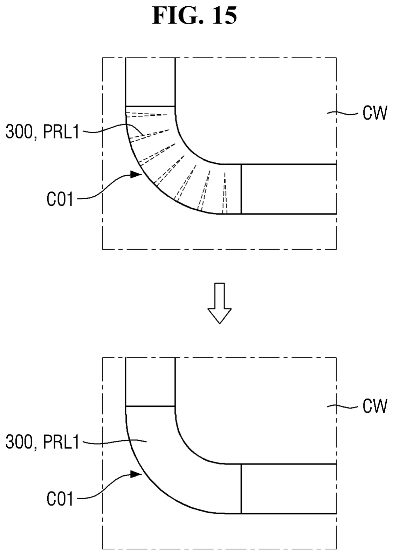

As shown in FIG. 15, strain may occur at the corners of the display panel 300 and the first protection member PRL1 during the above-described pressing step. When this happens, the display panel 300 contracts along with the first protection member PRL1 by heating of the guide member HG, so that the strain can be relieved.

As described above, the corner sections of the display device 10 are contracted by the heating of the guide member HG, and thus differences between the shape and curvature of the lower surface of the cover window CW disposed on the upper surface of the display panel 300 and the shape and curvature of the upper surface of the display panel 300 can be reduced.

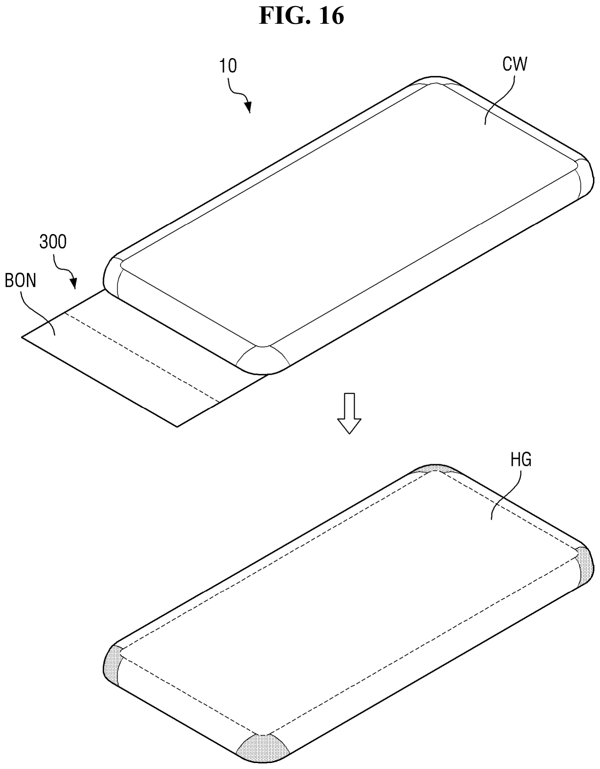

Subsequently, referring to FIG. 16, the guide member HG is removed (step S600). In this step, after the cover window CW and the display panel 300 are attached together, the guide member HG may be detached. In this manner, the display device 10 according to the embodiment can be fabricated.

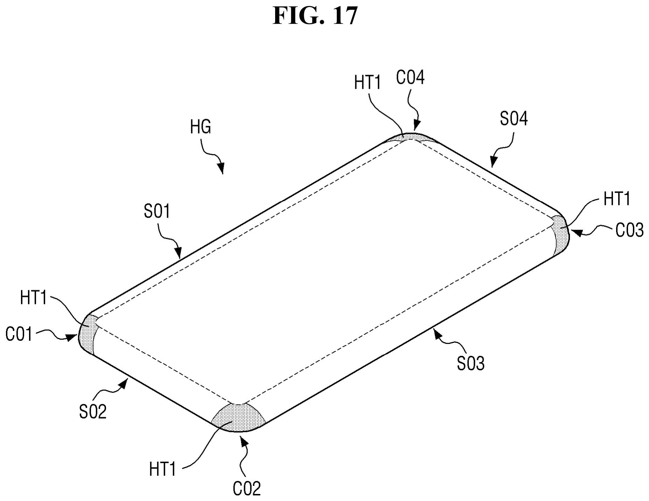

FIG. 17 is a perspective view showing a guide member according to another embodiment.

The embodiment of FIG. 17 is different from the embodiment of FIG. 12 in that second heaters disposed at curved portions SO: SO1, SO2, SO3 and SO4 are eliminated from of a guide member HG.

The side surfaces of the display device 10 have a curvature in one direction, so that strain applied to the display panel 300 and the first protection member PRL1 may be trivial. By eliminating the second heaters from the guide member HG which apply heat to the side surfaces of the display device 10, it is possible to simplify the complicated structure of the guide member HG.

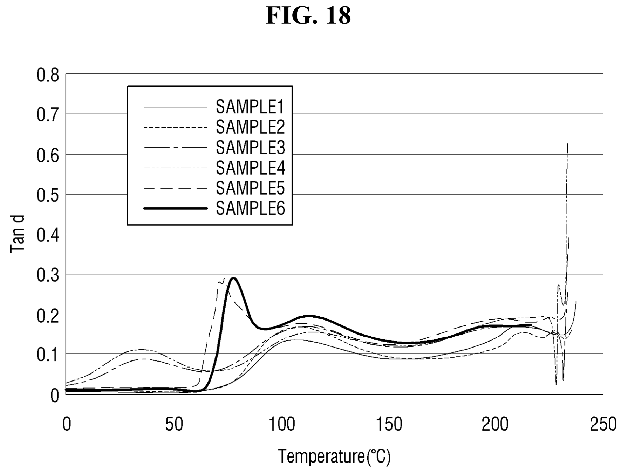

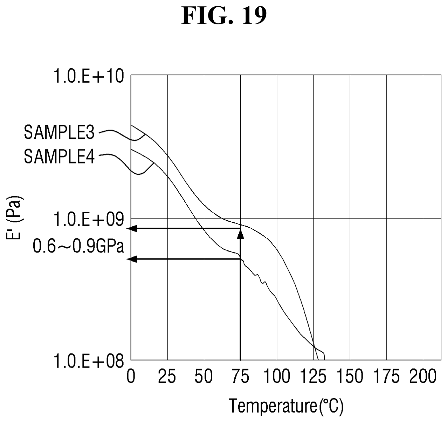

FIG. 18 is a graph showing glass transition temperatures of samples of protection members according to an embodiment. FIG. 19 is a graph showing elastic modulus at glass transition temperatures of the samples of the protection members according to the embodiment.

The glass transition temperature and the elastic modulus were measured using a dynamic mechanical analyzer (DMA) available from Perkin Elmer Inc. under the conditions of the heating rate of 2°C/min and the frequency of 2 Hz.

The samples of the protection members shown in FIG. 18 or 19 are as follows:
Sample 1: MD-elongated PET that has the elastic modulus of 4.5 GP and the thickness of 75 µm
Sample 2: TD-elongated PET that has the elastic modulus of 4.5 GP and the thickness of 75 µm
Sample 3: MD-elongated PET that has the elastic modulus of 1.6 GP and the thickness of 50 µm
Sample 4: TD-elongated PET that has the elastic modulus of 1.6 GP and the thickness of 50 µm
Sample 5: MD-elongated PET that has the elastic modulus of 3.6 GP and the thickness of 50 µm
Sample 6: TD-elongated PET that has the elastic modulus of 3.6 GP and the thickness of 50 µm
where MD (machine direction) elongation denotes elongation in the longitudinal direction of a film, and TD (transverse direction) elongation denotes elongation in the width direction of the film.

In the graph shown in FIG. 18, the horizontal axis represents the temperature, and the vertical axis represents the tangent delta (tan d), which is the ratio of the loss modulus to the storage modulus. The glass transition temperature of each of the sample may be the temperature at the point (or range) where the tan delta becomes maximum.

Referring to FIG. 18, the glass transition temperatures of Samples 5 and 6 are in the range of approximately 70 to 80 degrees Celsius, and the glass transition temperatures of Samples 1 to 4 are in the range of approximately 105 to 115 degrees Celsius.

That is to say, it can be seen that the protection members according to Samples 1 to 6 exhibited glass transition temperatures within the range of 50 to 150 degrees Celsius, and thus they can be used as the protection members of the display device 10 according to the embodiments of the present disclosure. In particular, the protection members according to Samples 3 to 6 exhibited low elastic moduli of 4 GPa or less and thus may be suitable the first protection member PRL1 overlapping the display area DA of the display device 10, and the protection members according to Samples 1 and 2 exhibited a high modulus of 4.5 GPa or more, and thus may be suitable for the second protection member PRL2 overlapping the bonding area BON of the display device 10.

In addition, referring to FIG. 19, Samples 3 and 4 exhibited elastic moduli of approximately 0.6 to 0.9 GPa at the glass transition temperature of approximately 75 degrees Celsius. That is to say, it can be seen that the protection members according to this embodiment exhibited an elastic modulus of 2.5 GPa or less in the range of the glass transition temperature. Accordingly, the protection members according to Samples 3 and 4 exhibit low elastic moduli of 2.5 GPa or less, and thus may be suitable for the first protection member PRL1 overlapping the display area DA of the display device 10.

Hereinafter, an experimental example of the display device according to the above-described embodiment will be described.

### < Experimental Example: Evaluating Lighting of Different Protection Members and Visual Inspection of Bonding Area >

A display device according to a Comparative Example was fabricated by attaching a PET film having the modulus of 4.5 GPa to the lower surface of each of the display area and bonding area of the display panel using an acrylic PSA and coupling it to a cover window.

A display device according to an Example was fabricated by attaching a PET film having the modulus of 5.5 GPa to the lower surface of the display area of the display panel using an acrylic PSA and attaching a PET film having the modulus of 4.5 GPa to the lower surface of the bonding area, and coupling them to a cover window.

Lighting of the display devices according to the Comparative Example and Example was evaluated, and then visual inspection was conducted after driver circuits are bonded to check for cracks or disconnection in the bonding area. The results are shown in Table 1 below:

**[Table 1]**

| | Lighting Percentage (%) | Visual Inspection |
|---|---|---|
| Comparative Example | 100 | No crack or disconnection |
| Example | 100 | No crack or disconnection |

Referring to Table 1, the display panel of the display device according to the Example in which the PET film having the low elastic modulus of 2.5 GPa was attached to the lower surface of the display area operated normally like that of Comparative Example, and no cracks or disconnections occurred at the bonding area. These results confirm that a high-quality display device can be manufactured even when protective members of different types, having different elastic modulus, are disposed in the display area and the bonding are of the display panel.

Although the embodiments of the present invention have been described above with reference to the accompanying drawings, it will be understood by those of ordinary skill in the art to which the present invention pertains that the present invention may be embodied in other specific forms without changing the technical spirit or essential characteristics of the present invention. Therefore, the embodiments described above are to be understood as illustrative in all respects and not restrictive.

## Claims

1. A display device comprising:
a display panel comprising a display area;
a cover window disposed on the display panel; and
a protection member disposed under the display area of the display panel,
wherein the protection member has an elastic modulus of 4 GPa or less in a range of glass transition temperature, and a contraction rate of 20% or more in a temperature range of 50 to 150 degrees Celsius.

2. The display device of claim 1, wherein the display area comprises:
a flat front surface;
side surfaces extended outward from edges of the front surface and curved with curvatures; and
corner sections each located between adjacent ones of the side surfaces and having double curvatures.

3. The display device of claim 2, wherein the protection member is attached to all of the front surface, the side surfaces, and the corner sections.

4. The display device of claim 1, further comprising:
a first coupling layer disposed between the display panel and the protection member; and
a second coupling layer disposed between the display panel and the cover window.

5. The display device of claim 1, wherein the glass transition temperature of the protection member ranges from 50 to 150 degrees Celsius.

6. The display device of claim 1, wherein the protection member has an elastic modulus of 0.6 to 0.9 GPa at a temperature range of 74 to 78 degrees.

7. The display device of claim 1, wherein the protection member comprises at least one of polyolefin-based, polyvinyl-based, polyethylene-based, and polyester-based resins.

8. The display device of claim 1, wherein the protection member has a thickness of 25 µm to 100 µm.

9. A display device comprising:
a display panel comprising a display area and a bonding area spaced apart from the display area;
a cover window disposed on the display panel;
a first protection member disposed under the display area of the display panel; and
a second protection member disposed under the bonding area of the display panel and spaced apart from the first protection member,
wherein a contraction rate of the second protection member is smaller than a contraction rate of the first protection member.

10. The display device of claim 9, wherein the contraction rate of the second protection member and the contraction rate of the first protection member are measured in a temperature range of 50 to 150 degrees Celsius.

11. The display device of claim 9, wherein the second protection member has a contraction rate of 1% or less in a temperature range of 50 to 150 degrees Celsius.

12. The display device of claim 9, wherein the second protection member has a coefficient of thermal expansion of 30 ppm/°C or less in a temperature range of room temperature to 180 degrees Celsius.

13. The display device of claim 9, wherein a melting point of the second protection member is equal to or greater than 180 degrees.

14. The display device of claim 9, wherein an elastic modulus of the second protection member is greater than an elastic modulus of the first protection member in a temperature range of 50 to 150 degrees Celsius.

15. The display device of claim 9, wherein the second protection member has an elastic modulus of 4.5 GPa or more in a temperature range of 50 to 150 degrees Celsius.

16. A method of fabricating a display device, the method comprising:
preparing a display panel, a first protection member and a second protection member;
attaching the first protection member and the second protection member to a lower surface of the display panel;
aligning a cover window on the display panel and a guide member under the display panel;
pressing the cover window, the display panel and the guide member;
heating the first protection member of the display panel through the guide member; and
removing the guide member,
wherein an elastic modulus of the second protection member is greater than an elastic modulus of the first protection member.

17. The method of claim 16, wherein the guide member comprises:
a flat portion;
curved portions extended outward from edges of the flat portion and curved with curvatures; and
double-curved portions each located between adjacent ones of the curved portions and having double curvatures.

18. The method of claim 17, wherein the guide member comprises first heaters disposed at the double-curved portions, and applies heat to the display panel and the first protection member through the first heaters.

19. The method of claim 18, wherein the guide member further comprises second heaters disposed at the curved portions, and applies heat to the display panel and the first protection member through the first heaters and the second heaters.

20. The method of claim 17, wherein a contraction rate of the second protection member is smaller than a contraction rate of the first protection member in a temperature range of 50 to 150 degrees Celsius.
